Europäisches Patentamt

European Patent Office

Office européen des brevets

(11) Publication number: **0 154 482**
**B1**

# (12) EUROPEAN PATENT SPECIFICATION

(45) Date of publication of patent specification: **16.05.90**

(51) Int. Cl.⁵: **C 23 C 16/02** // C03C25/02

(21) Application number: **85301250.8**

(22) Date of filing: **25.02.85**

(54) Coating process.

(30) Priority: **03.03.84 GB 8405649**

(43) Date of publication of application:
**11.09.85 Bulletin 85/37**

(45) Publication of the grant of the patent:
**16.05.90 Bulletin 90/20**

(84) Designated Contracting States:
**AT BE CH DE FR IT LI LU NL SE**

(56) References cited:
EP-A-0 036 191
DE-A-2 538 300
DE-A-3 202 709
FR-A-2 402 009
GB-A-1 115 884
GB-A-2 079 267
GB-A-2 105 371
GB-A-2 105 729
US-A-3 677 799
US-A-4 401 507

(73) Proprietor: **STC PLC**
**10, Maltravers Street**
**London, WC2R 3HA (GB)**

(72) Inventor: **Heinecke, Rudolf August Herbert**
**14 The Drive**
**Harlow Essex (GB)**
Inventor: **Ojha, Suresh Mishrilal**
**79 Carters Mead**
**Harlow Essex (GB)**

(74) Representative: **Dennis, Mark Charles**
**STC Patents West Road**
**Harlow Essex CM20 2SH (GB)**

Courier Press, Leamington Spa, England.

## Description

This invention relates to processes for the deposition of hermetic coating on a substrate surface.

Many electronic, electro-optic and optical devices are deleteriously effected by the presence of moisture. Provision of a moisture barrier is however by no means easy on a complex three dimensional structure and in general it is necessary to use some form of vapour deposition process. However conventional processes for the deposition of inorganic refractory materials require substrate temperatures in excess of 700°C, i.e. temperatures at which many devices are destroyed. Conventional plasma enhanced deposition techniques produce good refractory films at substantially lower temperatures, typically in the region of 350°C. Such temperatures however are still unacceptable for many applications. A lowering of the substrate temperature in such a process results in a surface coating having inadequate moisture barrier properties.

A further disadvantage of conventional coatings is the problem of thermal mismatch between the coating on the surface to which it is applied. In extreme cases this can lead to cracking of the coating and to loss of adhesion to the substrate surface.

In an attempt to overcome the disadvantages of conventional continuous plasma processes, discontinuous or pulsed plasma techniques have been introduced. Such a technique is described in Specification No. GB—A—2,105,729. This document teaches a process in which a substrate surface is treated by exposure to a high intensity pulsed radio frequency plasma of low average power. The process is employed inter alia for the provision of moisture impervious coatings on heat sensitive substrates. These coatings may comprise single layer or multilayer structures. Whilst this discontinuous process represents a significant improvement over conventional continuous plasma processing, problems have been experienced with prior adhesion of deposited film to the substrate surface.

According to one aspect of the present invention there is provided a process for providing an hermetic coating on a thermally sensitive substrate surface by deposition from a pulsed radio-frequency plasma, the process including depositing sequentially from the plasma on said surface a first silicon carbide coating which coating is thermally matched to said surface, and a second coating of silicon nitride on said first silicon carbide coating, there being a graded interchange between the first and second coatings.

According to another aspect of the present invention there is provided a process for providing an hermetic coating on a thermally sensitive substrate surface, the process including depositing sequentially from a pulsed radio frequency plasma a first oxide layer, a second carbide or nitride layer and a third organic polymeric layer.

We have found that pulsed plasma techniques may be employed to form a composite water repellent coating on a substrate surface without excessive heating of that surface. By providing a graded transition between a substrate compatible lower coating and a further surface coating the problem of mismatch between the substrate and the coating is overcome.

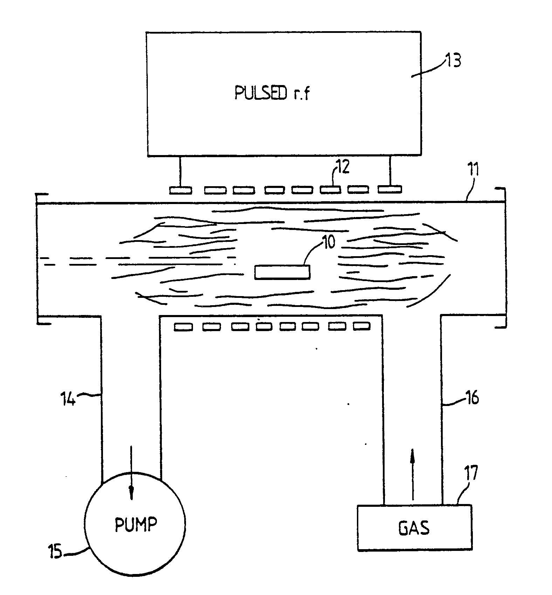

Embodiments of the invention will now be described with reference to the accompanying drawing in which the single figure is a schematic diagram of a pulsed plasma deposition apparatus.

Referring to the drawing, a device 10 whose surface is to be coated is mounted within a vacuum chamber 11. That portion of the chamber 11 in which the device 10 is mounted is surrounded by a coil 12 connected to a pulsed radio frequency generator 13. The power output of the generator 13 is not critical but must be sufficient to provide the desired surface deposition. We have found that a 60 kW generator is adequate for this purpose. The chamber may be evacuated via an outlet 14 leading to a pump 15 and may be supplied with gases or vapours from an inlet manifold 16 via an inlet tube 17.

In use the device 10 is inserted into the chamber 11 which is then evacuated through the outlet 14. If the device has external lead wires these may be masked by attaching masking chips (not shown) prior to the surface treatment. Advantageously a cleaning gas mixture is then admitted to the chamber via the inlet 17 and the generator is switched on to initiate the plams to provide a clear activated device surface for subsequent film deposition. The cleaning gas may comprise fluorine, oxygen, hydrogen or mixtures thereof, preferably in admixture with helium.

To provide an oxide/carbide/organic film structure, the chamber 11 is again evacuated and a mixture of oxygen and e.g. silicon or titanium tetrachloride is admitted to effect pulsed plasma deposition of an oxide film on the device surface. For some metallisation systems, e.g. gold wires, we prefer to deposit a strongly reduced oxide to promote metallurgical bonding under the oxide layer.

By gradually changing the inlet gas mixture to nitrogen, ammonia, or a hydrocarbon together with a volatile boron, silicon or transition metal compound a hermetic nitride or carbide layer is deposited on the device 10. The hermetic layer is then followed by a final organic layer. This final layer is preferably deposited from monomer gases chosen to give film structures similar to resin systems used in moulding compounds. The monomers may also include reactive groups such as epoxy or hydroxyl which will bond to a moulding compound where the device is subsequently encapsulated. In order to preserve the characteristic structure of the monomers in the deposited organic film the plasma pulses should be extremely short, typically 1 to 10 microseconds, in order to produce radicals with the minimum degree of dissolution.

In a further application, where a coated device is subsequently encapsulated in a moulded plastics material, a further hermetic coating may be applied. For this purpose the coating sequence is essentially reversed starting with surface etching and activation followed by a succession of layers with phased interfaces. An organic film is deposited and then, whilst increasing the pulse width, an organic layer such as silicon carbide is formed followed by a hydrophobic top layer e.g. of a fluorocarbon.

In a further application a silicon carbide/silicon nitride film structure may be deposited e.g. on a plastics or glass substrate surface. To effect this deposition a mixture of nitrogen, a hydrocarbon such as acetylene and silane is employed, the composition of the mixture being varied during the deposition process to provide a lower predominantly silicon carbide layer and an upper predominantly silicon nitride layer. Such a structure may be applied e.g. to an optical fibre. Advantageously a thin carbon precoat may be applied to the surface by deposition from a nitrogen/acetylene mixture prior to application of the coating.

The following examples illustrate the formation of graded surface coatings.

Example I

A LEXAN® polycarbonate substrate was provided with a carbon surface precoat by exposure to a pulsed plasma of an equi-volume acetylene/nitrogen mixture at a pressure of 2.7 newtons/m$^2$ (20 m torr) for 1 minute. The precoated substrate was then provided with a graded silicon carbide/silicon nitride coating using the following sequence.

| Pressure N m$^{-2}$ | Gas mixture | Time |
|---|---|---|
| 1.8 (11.0 m torr) | 30 $N_2$/20 $C_2H_2$/2 $SiH_4$ | 2 |
| 1.1 (8.5 m torr) | 30 $N_2$/10 $C_2H_2$/4 $SiH_4$ | 2 |
| 1.0 (7.8 m torr) | 30 $N_2$/5 $C_2H_2$/8 $SiH_4$ | 5 |
| 2.0 (15.0 m torr) | 30 $N_2$/1 $C_2H_2$/10 $SiH_4$ | 5 |

The nominal generator power was 55 kw. The pulse width was 250 μ sec. and the repetition frequency 5 Hz. The deposited film adhered strongly to the substrate and showed no sign of cracking when exposed to moisture. By comparison a plain silicon nitride film of similar thickness deposited from a mixture of 10 $SiH_4$/30 $N_2$/79 Ar at 2.7 newtons/m$^2$ (20 m torr) pressure displayed severe cracking and loss of adhesion on exposure to moisture.

Example II

A carbon/silicon carbide film was deposited on a LEXAN substrate by the following sequence:—

| Pressure N m$^{-2}$ | Gas mixture | Time |
|---|---|---|
| 2.7 (20 m torr) | $CH_4$ | 1 min |
| 2.7 (20 m torr) | He | 1 min |
| 2.7 (20 m torr) | Si/He | 1 min |
| 2.7 (20 m torr) | 10 $CH_4$/10 $SiH_4$ | 20 mins |

The generator power was 55 kw, the pulse width 100 μ sec at the repetition frequency 5 Hz. Again general quality moisture resistant fibres were obtained.

These examples illustrate the feasibility of the techniques described herein.

The processes described herein may be used on a wide variety of devices. They are however particularly suitable for the surface protection or passivation of semiconductor and electro-optic devices. They may also be employed for providing protective coatings on fibre optic devices.

**Claims**

1. A process for providing an hermetic coating on a thermally sensitive substrate surface by deposition from a pulsed radio-frequency playma, the process including depositing sequentially from the plasma on said surface a first silicon carbide coating which coating is thermally matched to said surface, and a second coating of silicon nitride on said first silicon carbide coating, there being a graded interchange between the first and second coatings.

2. A process as claimed in Claim 1 characterised in that said first and second coatings are deposited from gas mixtures of nitrogen, acetylene and silane.

3. A process as claimed in Claim 1 or 2 characterised in that said substrate is provided with a precoat of carbon.

4. A process as claimed in any one of Claims 1 to 3, characterised in that the pulse width is from 100 to 250 μ sec.

5. A process for providing an hermetic coating on a thermally sensitive substrate surface, the process including depositing sequentially from a pulsed radio frequency plasma a first oxide layer, a second carbide or nitride layer and a third organic polymeric layer.

6. A process as claimed in any one of Claims 1 to 5, characterised in that said substrate comprises an optical fibre.

**Patentansprüche**

1. Verfahren zur Schaffung einer hermetisch dichten Beschichtung auf einer thermisch empfindlichen Substratoberfläche durch Abscheidung aus einem gepulsten Hochfrequenzplasma, wobei bei dem Verfahren aufeinanderfolgend aus dem Plasma auf der Oberfläche eine erste thermisch an die Oberfläche angepaßte Siliziumkarbid-Beschichtung und eine zweite Beschichtung aus Siliziumnitrid auf der ersten Siliziumkarbidbeschichtung abgeschieden wird, und wobei sich ein gradueller Wechsel zwischen den ersten und zweiten Beschichtungen ergibt.

2. Verfahren nach Anspruch 1, dadurch gekennzeichnet, daß die ersten und zweiten Beschichtungen aus Gasmischungen aus Stickstoff, Acethylen und Silan abgeschieden werden.

3. Verfahren nach Anspruch 1 oder 2, dadurch gekennzeichnet, daß das Substrat mit einer Vorbeschichtung aus Kohlenstoff versehen wird.

4. Verfahren nach einem der Ansprüche 1 bis 3, dadurch gekennzeichnet, daß die Impulsbreite zwischen 100 und 250 μsec liegt.

5. Verfahren zur Schaffung einer hermetisch dichten Beschichtung auf einer thermisch empfindlichen Substratoberfläche, wobei das Verfahren die aufeinanderfolgende Abscheidung einer ersten Oxydschicht, einer zweiten Karbid- oder Nitridschicht und einer dritten organischen polymeren Schicht aus einem gepulsten Hochfrequenzplasma einschließt.

6. Verfahren nach einem der Ansprüche 1 bis 5, dadurch gekennzeichnet, daß das Substrat eine Lichtleitfaser umfaßt.

**Revendications**

1. Procédé pour obtenir un revêtement hermétique sur une surface de substrat thermosensible, par dépôt à partir d'un plasma à radiofréquences pulsées, le procédé comprenant le dépôt, successivement à partir du plasma sur ladite surface, d'un premier revêtement en carbure de silicium, ce revêtement correspondant thermiquement aux caractéristiques de ladite surface, et d'un second revêtement en nitrure de silicium sur ledit premier revêtement en carbure de silicium, avec existence d'une variation progressive de la composition entre les premier et second revêtements.

2. Procédé tel que revendiqué à la revendication 1, caractérisé en ce que lesdits premier et second revêtements sont déposés à partir de mélanges gazeux d'azote, d'acétylène et de silane.

3. Procédé tel que revendiqué à la revendication 1 ou 2, caractérisé en ce qu'on crée, sur ledit substrat, un revêtement préliminaire en carbone.

4. Procédé tel que revendiqué dans l'une quelconque des revendications 1 à 3, caractérisé en ce que la largeur ou durée des impulsions se situe entre 100 et 250 μs.

5. Procédé pour réaliser un revêtement hermétique sur une surface d'un substrat thermosensible, le procédé comprenant le dépôt successivement, à partir d'un plasma à radiofréquences pulsées, d'une première couche d'oxyde, d'une seconde couche de carbure ou de nitrure et d'une troisième couche de polymère organique.

6. Procédé tel que revendiqué dans l'une quelconque des revendications 1 à 5, caractérisé en ce que ledit substrat est constitué par ou, comprend, une fibre optique.